# EUROPEAN PATENT APPLICATION

(11) **EP 1 303 175 A1**
(43) Date of publication of application: **16.04.2003**
(21) Application number: 01124414.2
(22) Date of filing: 11.10.2001
(51) Int. Cl.: H05K 13/00

(54) **Device for plugging holes in printed circuit boards**

(71) Applicant: G.I.T. Co., Ltd., Tokyo (JP)
(72) Inventor: Takayanagi, Tadeshi, Kawasaki-City, Kanagawa-Pref. (JP)
(74) Representative: Stenger, Watzke & Ring Patentanwälte

(57) **Abstract**

In order to improve a device for plugging holes in printed circuit boards (5) comprising an inlet (2) for feeding printed circuit boards (5) to be plugged to the device, and conveyor means for conveying the printed circuit boards (5) through the device and across a plugging unit in which the holes are plugged and towards an outlet for releasing the printed circuit boards (5) out of the device in a way that a manual extraction step may be omitted therefore it may be incorporated in full automatic process lines it is suggested that such a device further comprises extraction means (12) located at the outlet for automatically extracting the printed circuit boards (5) out of the device said extraction means (12) comprising movable engagement members (16a, 16b, 17a, 17b) for engaging the printed circuit boards (5) to be extracted and driving means for moving the engagement members (16a, 16b, 17a, 17b) in order to extract the printed circuit boards (5) out of the device.

## Description

The present invention relates to a device for plugging holes in printed circuit boards comprising an inlet for feeding printed circuit boards to be plugged to the device, and conveyor means for conveying the printed circuit boards through the device and across a plugging unit in which the holes are plugged and towards an outlet for releasing the printed circuit boards out of the device.

In the field of electronics printed circuit boards, briefly PCB's, are used to assemble componentries which contain electronic circuits comprising several electric or electronic devices such as resistors, microprocessors, microcontrollers, memory-chips, inductors and the like. According to the particular design of the electric or electronic circuit desired electrically conductive pathways are formed on a substrate usually consisting of a resin material such as epoxy. To make the PCB's smaller so called multilayered PCB's have been used with several layers arranged in a sandwich-like structure therein each of the layers containing electrically conductive pathways. The electrically conductive pathways usually are formed of a conductive material such as copper, gold, carbon or the like. For such multi-layered PCB's it is necessary to drill so called via-holes to contact electrically conductive pathways of one layer with corresponding electrically conductive pathways of another layer. Such via-holes may extend only partially through the PCB or might cross the entire thickness of the PCB. After the contacts between layers have been formed these via-holes must be plugged again to avoid shortcuts or other undesired conditions and to protect the internal layers. Plugging of these holes is typically done with a device as described above.

The PCB with holes to be plugged is fed into the device via the inlet, processed inside the device (i.e. the holes are plugged by the plugging unit) and is extracted through the outlet.

For devices currently known the processed PCB's have to be manually extracted from the outlet. An operator has to watch the process and has to grip the forward end of the PCB coming out of the outlet and pull it out by using his hands. Often it is additionally necessary for the operator to use tools like wrenches or the like to be able to get hands on the forward edge of the PCB coming out of the system.

This extracting technique is disadvantageous in being complicated and labour-intensive. Additionally it is not possible to incorporate known hole-plugging devices into a fully automatically process of PCB processing. For known devices it is still necessary to have an operator taking the processed PCB out of the device and manually feeding it to subsequent processing devices.

Accordingly it is an object of the invention to provide a device for plugging holes in printed circuit boards of the above mentioned kind which allows to omit the manual extraction step and which therefore may be incorporated in full automatic process lines.

According to the invention this object is achieved by providing a device of the above mentioned kind which further comprises extraction means located at the outlet for automatically extracting printed circuit boards out of the device said extraction means comprising movable engagement members for engaging the printed circuit boards to be extracted and driving means for moving the engagement members in order to extract the printed circuit board out of the device.

By providing the extraction means at the outlet of the device according to the invention it is not necessary anymore to have an operator extracting the printed circuit boards processed by the device. The extraction will be performed automatically, instead. Additionally as human beings always are a possible source of errors the extraction will take place with a higher precision and with a lower number of mistakes, thus leading to a higher uptime of the device and a lower grade of spoilage.

According to a preferred embodiment of the invention the extraction means comprises two parallely extending shafts defining an elongated slit therebetween and being operationally connected with the driving means for rotating the shafts in opposite rotational directions said shafts each having mounted roller means thereon as engagement means for engaging the printed circuit boards on first and second surfaces. For such an extraction means the PCB will be fed into the elongated slit between the shafts and engaged by the roller means to be extracted. The roller means engage the PCB by means of friction and convey the PCB out of the outlet for extraction.

It is further preferred that each shaft has two rollers mounted thereon in axially spaced positions whereby the rollers of a first shaft together with rollers of the other shaft form two pairs of opposing rollers for engaging the surfaces of the printed circuit board on opposite sides. By means of this engagement the printed circuit board will be contacted by the rollers in an area limited to a minimum between two pairs of opposing rollers. As rollers mounted on the two shafts oppose each other they will have a tight grip on the surfaces of the PCB ensuring a reliable extraction.

In order to limit the surface areas of the PCB contacted by the rollers the two pairs of opposing rollers preferably are located at opposing side rims of the printed circuit boards to be extracted. As close to the edge of the PCB generally there are only registration and tooling holes located which shall not be plugged this area is the most suitable area to engage on. The center areas of the PCB where holes to be plugged are located will not be effected thereby minimizing the likelihood of possible removal of plugging substance in the plugged holes.

For ensuring that the rollers contact the PCB at the side rims and reliably guiding the PCB out of the device at least one of the rollers of each pair preferably comprises a stopper ring having a larger diameter than the roller and being arranged on a distal side of the roller with respect to the second, axially spaced roller mounted on the same shaft for confining the printed circuit board to be extracted between the pair of rollers. This confinement besides ensuring an engagement limited to the rim of the PCB also ensures a definite position to which the PCB is extracted. This definite position is important when the device according to the invention is incorporated in an automatic production line with further systems following the plugging device.

For minimum interference between the roller means and the PCB it is preferred that the roller means at least at a surface portion contacting the printed circuit board comprises a material, such as tempered urethan rubber, softer than the material of the printed circuit board. Silicone is a soft material on the one hand and on the other hand provides friction high enough for reliable extraction.

According to another preferred characteristic the roller means of the device comprises a fixing ring arranged around one of the shafts with a threaded hole extending radially through the fixing ring down to the lateral surface of the shaft and set screw means extending through the opening and engaging the thread for releasable clamping the fixing ring to the shaft. By means of this feature it is possible to fix and loosen the roller means and adjust its axial position on the shaft. This is a particularly useful feature if - as is usually the case - the device will be used for printed circuit boards of different dimensions. The fact that via the fixing ring the roller means might be loosened and shifted along the shaft the roller means might be adjusted in a position to engage only a defined portion of the PCB, e.g. the side margin.

For being able to adjust the position of the roller means the device according to the invention preferably comprises a lever means for radially separating the shafts. By means of this lever means the shafts might radially be separated in order to disengage opposing roller means for being able to individually change positions of the roller means.

In order to achieve a reliable extraction with an extraction speed matching with the conveyor speed in the device the driving means of the extraction means is preferably synchronised with a driving means of the conveyor means.

To be able to match the input position of the PCB with the extraction position the device of the invention preferably comprises adjustable guiding means located at the input for laterally confining the printed circuit boards to a defined position. With such guide means it is possible to adjust the lateral input position to be exactly the same as a lateral output position to guarantee a precise and reliable input transport through the device and extraction.

Further features and advantages of the device of the invention will be apparent to a person skilled in the art upon reading the following description of the preferred embodiment in conjunction with the accompanying drawings. In the drawings:
- Fig. 1: is a partially cut away, schematic side view of a hole plugging device according to the invention;
- Fig. 2: is a schematic view of an extraction means according to the invention located at the outlet of the device shown in Fig. 1; and
- Fig. 3: is a respective, schematic view of the inlet of the device shown in Fig. 1 showing guide means for guiding PCB's fed into the device.

In the figures like reference numbers denote like parts. The figures are schematic drawings and not necessarily to scale. The figures are given for illustrative purposes only and shall not be seen as limiting the invention.

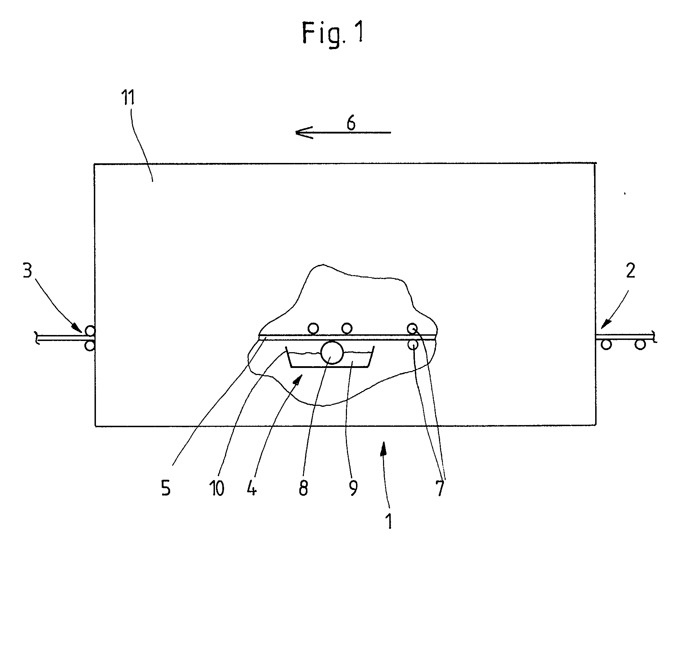

Referring to Fig. 1 a hole plugging device 1 is schematically shown partially cut away. The device 1 comprises an inlet 2 and an outlet 3 for feeding or extracting a printed circuit board (PCB) 5 to the device 1 or from the device 1 respectively. The device 1 further comprises a plugging unit 4 having e.g. an ink-reservoir 10 containing ink 9 and an ink-application-roll 8 partially dipped into the ink 9 and contacting the surface of the PCB 5 onto which the ink 9 is to be applied. The device 1 further comprises conveying means e.g. in form of transport rolls 7 for conveying the PCB in a conveying direction 6. The device 1 is enclosed in a housing 11.

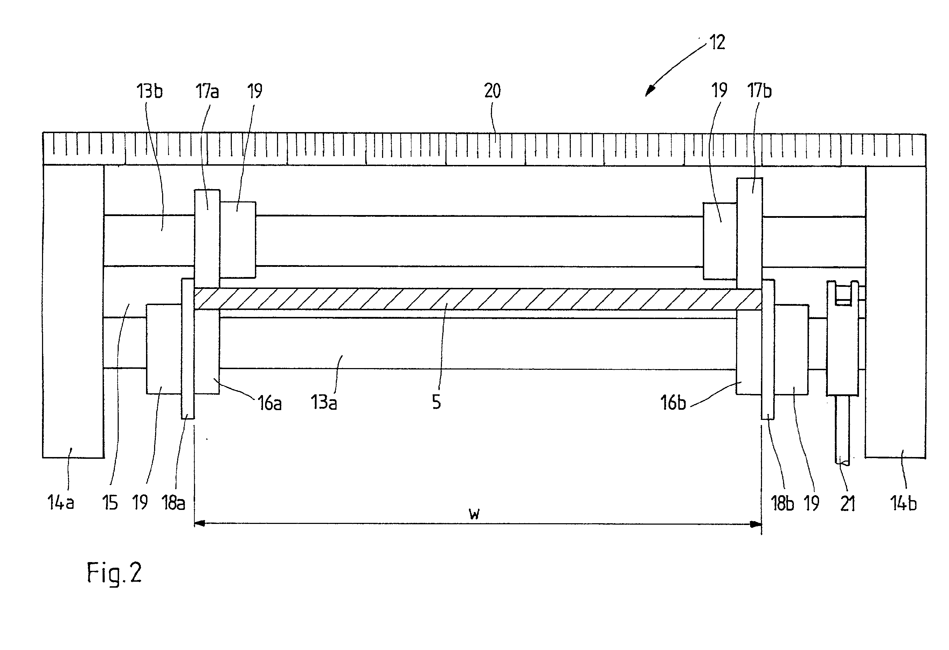

For plugging holes in a PCB a PCB is inserted into the device 1 via the inlet 2, conveyed by conveying rolls towards the plugging unit 4 where a plugging substance, e.g. ink 9, is applied to a surface of the PCB, further conveyed towards the outlet 3 and there automatically extracted by means of an extraction means which will be further described with reference to Fig. 2.

Referring to Fig. 2 an embodiment for an extraction means 12 according to the invention is schematically shown. The extraction means 12 comprises two parallel aligned shafts 13a, 13b rotatably mounted to lateral frame members 14a, 14b. The shafts are arranged in a way that there is provided a spacing in between them in form of an elongated slit 15. Mounted on each of the shafts 13a, 13b are two lower extraction rollers 16a, 16b and two upper extraction rollers 17a, 17b respectively. The lower extraction rollers 16a, 16b are mounted on the lower extraction shaft 13a and are axially spaced. The upper extraction rollers 17a, 17b mounted on the upper extraction shaft 13b are likewise axially spaced. The lower extraction roller 16a and the upper extraction roller 17a are sited in opposing positions and together form a co-operating pair of extraction rollers. Likewise the lower extraction roller 16b and the upper extraction roller 17b together form another co-operating pair of opposing extraction rollers. The lower extraction rollers 16a and 16b comprise stopper rings 18a, 18b respectively. The stopper rings 18a, 18b are located at the side of the respective extraction roller 16a, 16b which is closer to the nearestby frame member 14a, 14b respectively. Each of the upper and lower extraction rollers 16a, 16b and 17a, 17b is fixedly connected with a mounting ring 19. The mounting rings 19 comprise threaded holes (not shown) extending therethrough all the way to the shaft 13a, 13b respectively. Sited in the threaded holes are set screws (not shown) releasable fixing the mounting rings 19 to the respective shaft.

A scale 20, extending parallel to the shafts 13a, 13b is provided with a plurality of marks, e.g. in the range of millimetres. Finally a lever 21 is arranged for separating the shafts 13a, 13b in a radial direction by means of an eccentric element in order to enlarge the elongated slit 15 in a direction perpendicular to the extension of the shafts 13a and 13b.

The surface portions of the lower and upper extraction rollers 16a, 16b and 17a, 17b are made of tempered urethan rubber in order to achieve a maximum grip with the surface of a PCB 5 on the one hand and to avoid unwanted interferences between the material of the PCB 5 and the rollers on the other hand.

Prior to a plugging process the lateral dimensions of the PCB's 5 to be plugged are measured and the width w between the stopper rings 18a and 18b of the lower extraction rollers 16a ands 16b is adjusted. To be able to adjust the width lever 21 is actuated in order to separate the shafts 13a and 13b from each other to disengage the upper and lower extraction rollers 16a, 16b and 17a, 17b respectively. Then the set screws of the mounting rings 19 are loosened and lower and upper extraction rollers 16a, 16b and 17a, 17b are shifted along the respective shaft 13a, 13b in order to adjust their suitable positions. For a convenient adjustment the positions of the rollers and the distance between the rollers may be read out from the scale 20. When all four rollers are adjusted to a position matching with the dimensions of the PCB 5 to be plugged the set screws of the mounting rings 19 are fastened again and the lever 21 is released in order to close up the elongated slit 15 and bring the lower end upper extraction rollers 16a, 16b and 17a, 17b into an operating position again.

During operation of the device 1 the shafts 13a and 13b are driven in opposite directions in order to provide a PCB with an outwardly directed extraction force. The drive (not shown) for the shafts 13a, 13b is synchronised with the drive for a conveying means for a precise operation of the whole device 1.

When a PCB 5 during the operation of the device 1 approaches the extraction rollers 16a, 16b, 17a, 17b the extraction rollers grip the PCB at the lateral rims and by means of the friction between the material of the rollers and the surface of the PCB 5 convey it through the outlet 3. The stopper rings 18a, 18b prevent the PCB 5 from a lateral displacement and ensure a definite extraction position as adjusted by the adjustment procedure described above.

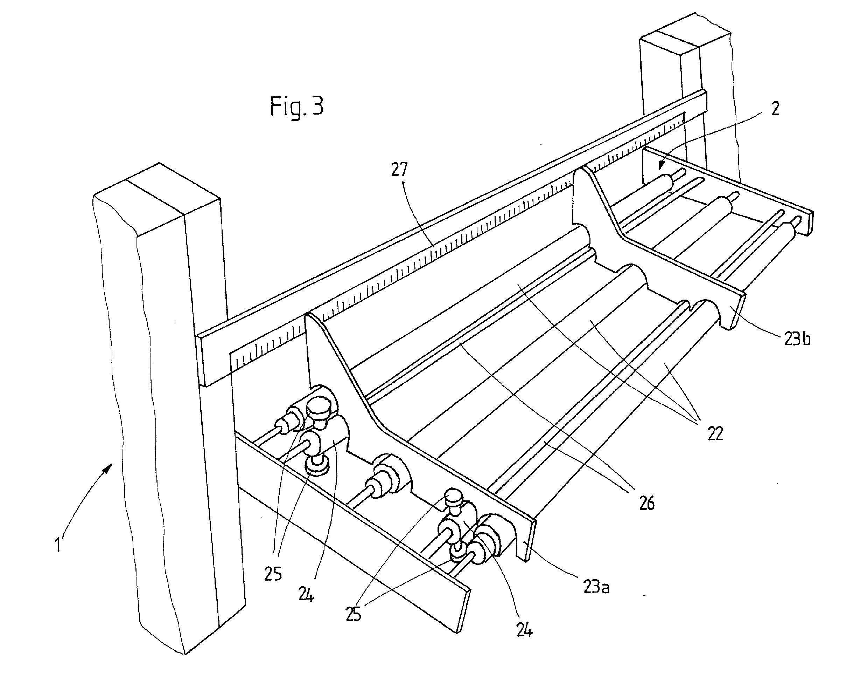

Referring now to Fig. 3 there is schematically shown a perspective view of the inlet 2 of the device 1. Inlet rolls 22 are provided for laying down a PCB 5 to be fed into the device 1 thereon. Guiding plates 23a, 23b are arranged for providing a lateral confinement to the PCB 5 fed into the inlet 2 of the device 1. The guiding plates 23a, 23b are releasably fixed to axles 26 by means of mounting rings 24 and set screws 25 in the same manner as described above with respect to the mounting rings 19 of the engagement rollers 16a, 16b, 17a, 17b in Fig. 2.

A scale 27 is provided with markings e.g. on the millimetre-scale to assist in adjusting the guiding plates 23a, 23b. Preferably the scale 27 on inlet 2 side of device 1 has the same scale and the same scale numbers at corresponding positions of the device as the scale 20 at the outlet 3 side of the device. This enables an operator to easily adjust the guiding plates 23a, 23b at the inlet 2 side of the device 1 corresponding to the positions of the stopper rings 18a, 18b of the lower extraction rollers 16a, 16b at the outlet 3 side of the device. By means of the guiding plates 23a, 23b the PCB's 5 can reliably be fed into the device 1 with a lateral position that they will be taken out at the outlet 3 side of the device 1 after the plugging process is finished.

The present invention provides a device for plugging holes in printed circuit boards which allows to omit a manual extraction of the PCB after the plugging is finished and thus allows to safe labour time and to increase the precision of the extraction. Furthermore it is possible with the device of the invention to incorporate the device into an automatically operating production line.
- 1: hole plugging device
- 2: inlet
- 3: outlet
- 4: plugging unit
- 5: PCB
- 6: conveying direction
- 7: transport roll
- 8: ink-application roll
- 9: ink
- 10: ink reservoir
- 11: housing
- 12: extraction means
- 13a: shaft
- 13b: shaft
- 14a: frame member
- 14b: frame member
- 15: elongated slit
- 16a: lower extraction roller
- 16b: lower extraction roller
- 17a: upper extraction roller
- 17b: upper extraction roller
- 18a: stopper ring
- 18b: stopper ring
- 19: mounting ring
- 20: scale
- 21: lever
- 22: inlet roll
- 23a: guiding plate
- 23b: guiding plate
- 24: mounting ring
- 25: set screw
- 26: axis
- 27: scale
- w: width

## Claims

1. Device for plugging holes in printed circuit boards (5) comprising an inlet (2) for feeding printed circuit boards (5) to be plugged to the device, and conveyor means (7) for conveying the printed circuit boards (5) through the device and across a plugging unit (4) in which the holes are plugged and towards an outlet (3) for releasing the printed circuit boards (5) out of the device, set device being **characterised**
**in** further comprising extraction means (12) located at the outlet (3) for automatically extracting the printed circuit boards (5) out of the device said extraction means (12) comprising movable engagement members (16a, 16b, 17a, 17b) for engaging the printed circuit boards (5) to be extracted and driving means for moving the engagement members (16a, 16b, 17a, 17b) in order to extract the printed circuit boards (5) out of the device.

2. Device according to claim 1 **characterised in that** said extraction means (12) comprises two parallely extending shafts (13a, 13b) defining an elongated slit (15) therebetween and being operationally connected with said driving means for rotating the shafts (13a, 13b) in opposite rotational directions, said shafts each having mounted roller means (16a, 16b, 17a, 17b) thereon as engagement means for engaging the printed circuit boards (5) on first and second surfaces.

3. Device according to claim 2 **characterised in that** each shaft (13a, 13b) has two rollers (16a, 16b; 17a, 17b) mounted thereon in axially spaced positions whereby the rollers (16a, 16b) of a first shaft (13a) together with the rollers (17a, 17b) of the other shaft (13b) form two pairs of opposing rollers (16a, 17a; 16b, 17b) for engaging the surface of the printed circuit board (5) on opposite sides.

4. Device according to claim 3 **characterised in that** the two pairs of opposing rollers (16a, 17a; 16b, 17b) are located at opposing side rims of the printed circuit boards (5) to be extracted.

5. Device according to claim 4 **characterised in that** at least one of the rollers (16a, 16b) of each pair of rollers comprises a stopper ring (18a, 18b) having a larger diameter than the roller (16a, 16b) and being arranged on a distal side of the roller (16a, 16b) with respect to the second, axially spaced roller (16b, 16a) mounted on the same shaft (13a) for confining the printed circuit board (5) to be extracted between the pair of rollers (16a, 16b).

6. Device according to anyone of claims 2 to 5 **characterised in that** the roller means (16a, 16b, 17a, 17b) at least at a surface portion contacting the printed circuit board (5) comprises a material, such as tempered urethan rubber, softer than the material of the printed circuit board (5).

7. Device according to anyone of claims 2 to 6 **characterised in that** the roller means (16a, 16b, 17a, 17b) is releasably mounted to the shafts (13a, 13b) and axially displaceable in order to adjust a desired position of the roller means (16a, 16b, 17a, 17b).

8. Device according to claim 7 **characterised in that** the roller means (16a, 16b, 17a, 17b) comprises at least one fixing ring (19) arranged around one of the shafts (13a, 13b) with a threaded hole extending through said fixing ring (19) down to the lateral surface of the shaft (13a, 13b) and set screw means extending through the opening and engaging the thread for releasably clamping the fixing ring (19) to the shaft (13a, 13b).

9. Device according to anyone of the claims 2 to 8 **characterised in that** it further comprises lever means (21) for radially separating the shafts (13a,13b).

10. Device according to anyone of claims 1 to 9 **characterised in that** the driving means of the extraction means (12) is synchronised with a driving means for the conveyor means (7).

11. Device according to anyone of claims 1 to 10 **characterised in that** it further comprises an adjustable guiding means (23a, 23b) located at the input (2) for laterally confining the printed circuit board (5) to a defined feeding position.
